# EUROPÄISCHE PATENTANMELDUNG

(11) **EP 2 703 826 A2**
(43) Veröffentlichungstag der Anmeldung: **05.03.2014**
(21) Anmeldenummer: 13181772.8
(22) Anmeldetag: 27.08.2013
(51) Int. Cl.: G01R 1/067

(54) **Messzange für symmetrische Datenkabel**

(30) Priorität: 30.08.2012 DE 102012215427
(71) Anmelder: GHMT AG, 66450 Bexbach (DE)
(72) Erfinder: Wilhelm, Dirk, 66851 Hauptstuhl (DE); Jung, Bernd, 66386 St. Ingbert (DE); Grüner, Stefan, 66882 Hütschenhausen (DE); Onnenga, Malte, 66123 Saarbrücken (DE)
(74) Vertreter: Kruspig, Volkmar

(57) **Zusammenfassung**

Es wird eine Messzange zur Adaptierung zwischen symmetrischen Datenkabel mit mehreren Loterpaaren, insbesondere einem Twisted-Pair. Kabel, und asymmetrischen Messtoren eines Netzwerk-Analysegeräts zur Messung der charakteristischen HF-Eigenschaften des Kabels bereitgestellt, mit einer Halterung zum Fixieren eines Endes des zu messenden Kabels und einem sich in Längsrichtung verjüngenden Spreizkörper mit in der Mantelfläche des Spreizkörpers gebildeten länglichen Vertiefungen zum Einlegen und rotationssymmetrischen Aufspreizen der Leiterpaarenden des Kabels, um zu erreichen, dass die Einzeladern und Schirme des Kabels korrekt angeschlossen werden, dass die Auswirkungen auf die Messung durch die Messzange selbst minimiert sind, dass die freie Weglänge der Leiterpaarenden ohne Schirm verkürzt ist, und dass die Rückflussdämpfung im Bereich der Übergänge von den Kabeladern zu den an der Messzange angeschlossenen Koaxialkabel optimiert ist.

## Beschreibung

Die Erfindung betrifft eine Messzange für HF-Messungen an symmetrischen Datenkabeln, insbesondere für Messungen an sogenannten Twisted-Pair-Kabeln, zur Charakterisierung der HF-Eigenschaften besagter Kabel.

Symmetrische Datenkabel werden eingesetzt zur symmetrischen Datenübertragung. Sie umfassen ein oder mehrere gegeneinander isolierte Adern- oder Leiterpaare. Bei sog. "Twisted-Pair"-Kabel sind zur Optimierung der elektromagnetischen Eigenschaften zusätzlich die Adern- oder Leiterpaare miteinander verdrillt. Für die unsymmetrische Datenübertragung, auch asymmetrische Datenübertragung genannt, wird typischerweise eine Koaxialleitung verwendet.

Bei derzeit verwendeten symmetrischen Datenkabeln, wie z. B. den 4-fach Twisted-Pair-Kabeln (EN50173-1, ISO/IEC 11801, IEC61156 bzw. TIA/EIA568), sind zur Charakterisierung der HF-Eigenschaften bereits Messungen im Frequenzbereich von bis zu 1 GHZ erforderlich. Durch die ständige Weiterentwicklung auf dem Gebiet der Übertragungstechnik und den damit einhergehenden erhöhten Anforderungen an die zu übertragenden Datenraten werden auch in Zukunft die Übertragungsbandbreiten weiter ansteigen.

Um die symmetrischen Kabelanschlüsse des zu messenden Kabels an die unsymmetrischen Messtore eines Netzwerkanalysegeräts anzuschließen, ist ein Messadapter erforderlich. Der Messadapter muss dabei stets deutlich bessere Eigenschaften als das Messobjekt aufweisen, damit bei der höchsten Messfrequenz die Messungen von Dämpfung, Rückflussdämpfung (RL) und Übersprechdämpfung (z.B. NEXT/FEXT) keinerlei negative Beeinträchtigung erfahren.

Aus der DE 195 12 947 C1 ist ein Messadapter mit integrierten Baluns bekannt. Ein Balun betrifft allgemein ein Bauteil zur Wandlung zwischen einem symmetrischen Signal und einem asymmetrischen Signal. Vor allem in der Hochfrequenztechnik wird auch die Bezeichnung Symmetrierglied verwendet. Im Falle z. B. eines 4-fach Twisted-Pair-Kabels kommt ein 2-Tor-Netzwerkanalysator mit Baluns zum Einsatz. Aufgrund der parasitären Eigenschaften solcher Symmetrierglieder bzw. Baluns ist es jedoch nicht möglich, einen Frequenzbereich von größer als 1 GHz zu erreichen.

Weiterhin ist aus der GB 93 10 745 eine Messzange für das Messen der Eigenschaften eines 4-fach Twisted-Pair-Kabels bekannt. Die Messzange zielt darauf ab, die Reproduzierbarkeit von elektrischen Messungen zu gewährleisten, indem die mechanischen Bedingungen der Messung möglichst konstant gehalten werden. Dies wird durch eine Messzange mit Halterung erreicht, in weicher das Kabelende geradlinig einspannbar ist. An der Schnittstelle zwischen den symmetrischen Kabelenden und den unsymmetrischen Messtoren des Analysegeräts ist ein Messadapter bzw. Übertrager angeordnet. Der bekannte Messadapter umfasst Anschlagmittel, an welchen die Leiterpaarenden des Kabels angeschlagen werden. Das zu messende Kabel ist zentral angeordnet und die Anschlagmittel sind mit gleichem Abstand von der Kabelachse drehsymmetrisch zu dieser angeordnet. Die einzelnen Leiterpaarenden des abisolierten Kabels sind entsprechend ihrer Lage im Kabelmantel überkreuzungsfrei freiliegend nach außen gelegt und stehen im rechten Winkel zueinander. Weiterhin umfasst der Messadapter Koaxialkabelanschlüsse, die mit den jeweiligen Anschlussmitteln elektrisch verbunden sind.

Zur vollständig automatischen Charakterisierung von Kabeln werden im Falle eines 4-fach Twisted-Pair-Kabels 8 Messtore benötigt, nämlich 4 Messtore des Netzwerk-Analysegeräts an einem Ende des Kabels und 4 Messtore des Netz-werk-Analysegeräts an dem anderen Ende des Kabels. Die symmetrischen S-Parameter werden rechnergestützt aus den unsymmetrischen Einzelmessungen ermittelt.

Der Erfindung liegt die Aufgabe zugrunde, eine Messzange derart weiterzubilden, dass Messungen der HF-Eigenschaften eines Kabels auch im höheren Frequenzbereich über 1 GHz störungsfrei durchführbar sind.

Diese Aufgabe wird durch die Messzange gemäß Anspruch 1 mit Weiterentwicklungen in den Unteransprüchen gelöst.

Erfindungsgemäß geschieht dies mit Hilfe eines sich in Längsrichtung verjüngenden Spreizkörpers mit in dessen Mantelfläche gebildeten länglichen Vertiefungen zum Einlegen und rotationssymmetrischen Aufspreizen der Leiterpaarenden des Kabels.

Die Erfindung zielt darauf ab, zum einen sicherzustellen, dass die Einzeladern und Schirme des Twisted-Pair-Kabeis korrekt an die Anschlussbuchsen (üblicherweise SMA-Messbuchsen) angeschlossen werden. Zum anderen ist die Konstruktion der Messzange derart, dass Auswirkungen auf die Messung durch die Messzange selbst minimiert sind. Durch das Einlegen der Leiterpaarenden in längliche Vertiefungen ist die freie Weglänge der Leiterpaarenden ohne Schirm verkürzt. Die Rückflussdämpfung im Bereich der Übergänge von Kabeladern zu den 50 Ω-Leitungen der an die Messzange angeschlossenen Koaxialkabel ist damit optimiert.

Nach einer vorteilhaften Ausgestaltung der Erfindung ist in der Halterung eine Aufnahmeausnehmung gebildet, in der der Spreizkörper mit dem verjüngten Ende der Halterung zugewandt zumindest teilweise derart aufnehmbar ist, dass die Längsachse des Spreizkörpers mit der Kabelachse zusammenfällt. Somit ist eine verbesserte Schirmung der freigelegten Leiterpaarenden gegeben. Vorzugsweise korrespondiert die Aufnahmeausnehmung im Wesentlichen mit der Grundform des Spreizkörpers, so dass im Zusammenwirken von Spreizkörper und Aufnahmeausnehmung eine automatische Zentrierung des Spreizkörpers relativ zu dem in der Halterung eingespannten Kabel erfolgt. Weiterhin sind die länglichen Vertiefungen in der Mantelfläche des Spreizkörpers und/oder der Oberfläche der Aufnahmeausnehmung gebildet, und zwar derart, dass im Zusammenwirken von Spreizkörper und Aufnahmeausnehmung je Leiterpaar ein separater, in Umfangsrichtung geschlossener Schirmkanal gebildet wird. Hierdurch ergeben sich entsprechende separate geschirmte Kammern für die Kabelpaare. Vorteilhafterweise ist die Übersprechdämpfung optimiert bzw. erhöht, so dass Messungen von bis zu 4 GHz möglich sind.

Der Spreizkörper ist pyramidenförmig mit einem regelmäßigen oder punktsymmetrischen Polygon als Grundfläche, insbesondere pyramidenstumpfförmig und vorzugsweise kegelförmig, insbesondere kegelstumpfförmig gebildet. Die Kegelstumpfform ist dabei besonders vorteilhaft, da durch die gekappte Kegelspitze Beschädigungen der aus den abisolierten Kabelöffnungen austretenden Leiterpaarenden vermeidbar sind. Ferner ist im Falle einer rotationssymmetrischen Kegelstumpfform eine Feinjustierung der Drehlage des Spreizkörpers mit den aufgespreizten Leiterpaarenden relativ zur Halterung und damit zu dem Kabel in einfacher Weise durchführbar.

Im Querschnitt betrachtet sind die Vertiefungen trapezförmig, insbesondere rechteckförmig, dreieckförmig oder halbrundförmig gebildet.

Auf dem aufgeweiteten Ende des Spreizkörpers ist senkrecht zu dessen Längsachse eine Leiterplatte mit, vorzugsweise vergoldeten, radialen Leiterbahnen angeordnet, zum Verbinden der Kabelpaarenden mit den jeweiligen Anschluss- bzw. Koaxialkabelbuchsen, die radial weiter außen in gleichem Abstand von der Längsachse liegend in Umfangsrichtung um die Leiterplatte angeordnet sind. Da ein Teil der elektrischen Verbindung zwischen den Anschluss- bzw. Koaxialkabelbuchsen (insbesondere SMA-Messbuchsen) und den Leiterkabelenden durch die Leiterbahnabschnitte erfolgt, sind die "entdrillten" Abschnitte der Leiterpaarenden verkürzt, wodurch Störeffekte minimiert sind. Die Leiterbahnen sind auf der der Halterung gegenüberliegenden Seite der Leiterplatte angeordnet, so dass die andere, der Halterung zugewandte Seite frei von Leiterbahnen ist und an der Halterung anliegen, insbesondere plan aufliegen kann.

Die Anschlussklemmen zum Verbinden der Leiterpaarenden mit den Leiterbahnen sind vorzugsweise in gleichen Abständen von der Spreizkörperlängsachse angeordnet, um eine symmetrische Spreizanordnung zu bilden. Zur Abschirmung der Anschlussklemmen, der Leiterbahnen sowie der Koaxialkabelbuchsen ist ein Schirmdeckel auf der der Halterung gegenüberliegenden Seite der Leiterplatte angeordnet.

In der Leiterplatte und in dem Schirmdeckel sind zentrale Durchgangsöffnungen gebildet, deren Durchmesser kleiner sind als der Querschnitt des aufgeweiteten Endes des Spreizkörpers. An dem aufgeweiteten Ende des Spreizkörpers ist wiederum ein Schaft mit einem Schraubengewinde angeordnet, insbesondere drehfest mit diesem verbunden, der sich durch die Durchgangsöffnungen erstreckt, zur Verschraubung mit einer Deckeiverschraubung, um die Leiterplatte gegen den Schirmdeckel zu fixieren.

Um bei der Verschraubung mittels der Deckelverschraubung die Leiterplatte beim Pressen gegen den Schirmdeckel nicht zu beschädigen, sind in dem Schirmdeckei in Richtung auf den Spreizkörper vorgespannte Federstifte angeordnet. Die Federstifte sind derart angeordnet und vorgespannt, dass bei Verschraubung des Schirmdeckels (12) mittels der Deckelverschraubung (15) die Leiterpaarenden und die Leiterbahnen durch die Federstifte (16) mit einer definierten gleichbleibenden Kraft entsprechend der Vorspannkraft der Federstifte (16) miteinander in Kontakt gedrückt werden.

Typischerweise bestehen symmetrische Datenkabel aus vier einzelnen Aderpaaren, wobei jedes Aderpaar einzeln oder alle Aderpaare gemeinsam geschirmt sein können und von dem Kabelmantel umschlossen werden.

Weitere Merkmale und Vorteile der Erfindung ergeben sich aus der folgenden Beschreibung anhand der beigefügten Figuren, in denen
- Fig. 1A: eine teilweise Explosionsansicht im Schnitt entlang der Linie A-A in Fig. 4 einer Messzange gemäß der Erfindung mit dem zu messenden Kabel zeigt;
- Fig. 1B: eine Ansicht der Messzange im Schnitt in Fig. 1A im zusammengesetzten Zustand zeigt;
- Fig. 2: eine Ansicht von rechts des Spreizkörpers in den Fig. 1A und 1B zeigt;
- Fig. 3: eine Ansicht von links der Messzange in Fig. 1B zeigt;
- Fig. 4: eine Ansicht von rechts der Messzange in Fig. 1B zeigt und

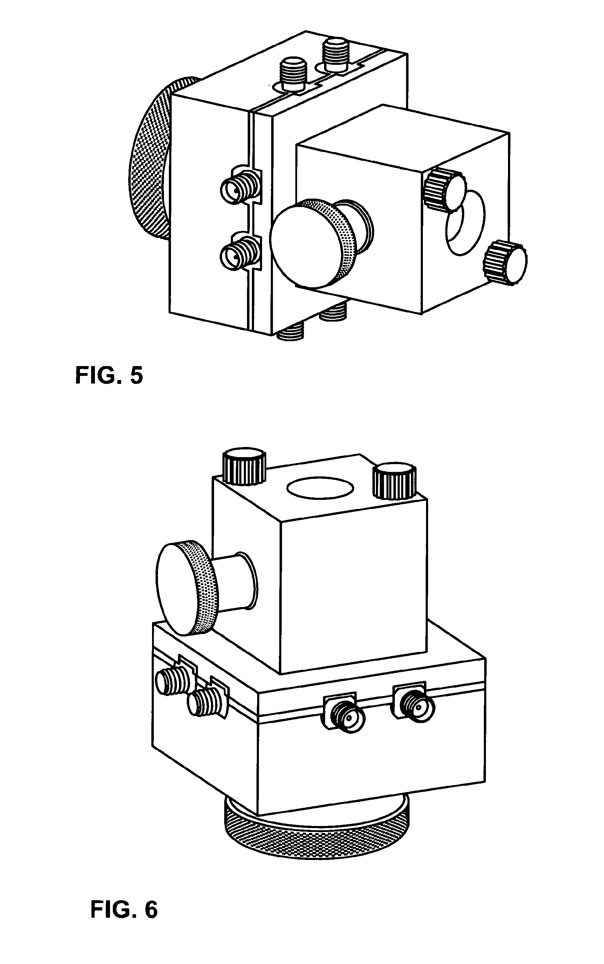

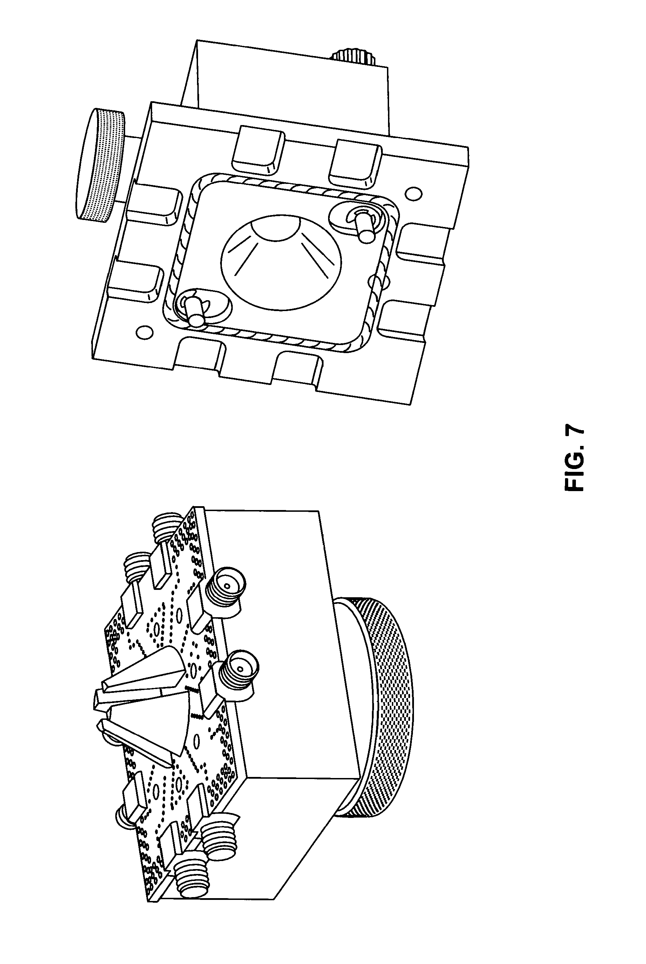

- Fig. 5 bis 7: fotorealistische Abbildungen der Messzange.

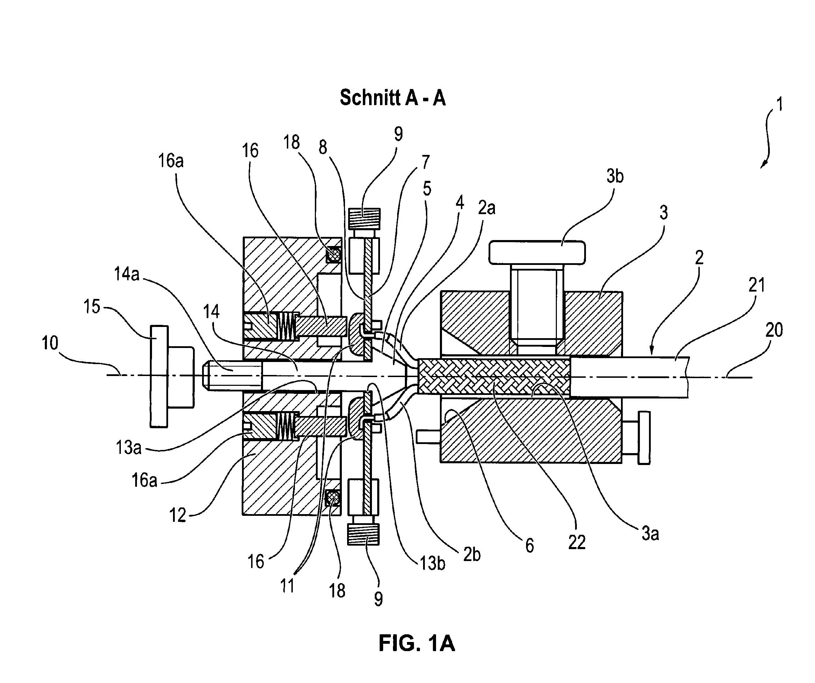

Fig. 1A zeigt den modularen Aufbau der Messzange 1 in einer teilweise explodierten Ansicht. In einer Halterung 3 ist das zu messende Kabel 2 geradlinig eingespannt. Die Halterung 3 kann eine obere und untere Backe mit einer darin gebildeten Längsrille 3a zum Einlegen des Kabels 2 umfassen. Bei dem in den Figuren gezeigten Kabelabschnitt handelt es sich jeweils um ein Kabelende. Wie in Fig. 1A zu sehen, ist eine Fixierschraube 3b vorgesehen, die sich quer zur Längsrille 3a, in der das Kabel 2 eingelegt ist, in der Halterung 3 erstreckt. In Fig. 1A ist die Fixierschraube 3b gelöst und das Kabelende ragt aus der Halterung 3. In der Halterung 3 ist weiterhin eine kegelförmige Aufnahmeausnehmung 6 zur Aufnahme eines nachfolgend näher beschriebenen Spreizkörpers 4 gebildet, wobei die Längsachse 10 der Aufnahmeausnehmung 6 mit der Längsachse 20 des Kabels 2 zusammenfällt.

Das Kabel 2 ist mit am Kabelende entferntem Kabelmantel 21 gezeigt. In diesem abisolierten Abschnitt ist die Schirmung 22 zu sehen. In einem Endabschnitt ist schließlich auch die Schirmung entfernt und es sind die Leiterpaarenden 2a-2d (von denen nur die Leiterpaarenden 2a und 2b in der Figur zu sehen sind) in gespreizter Anordnung zu sehen.

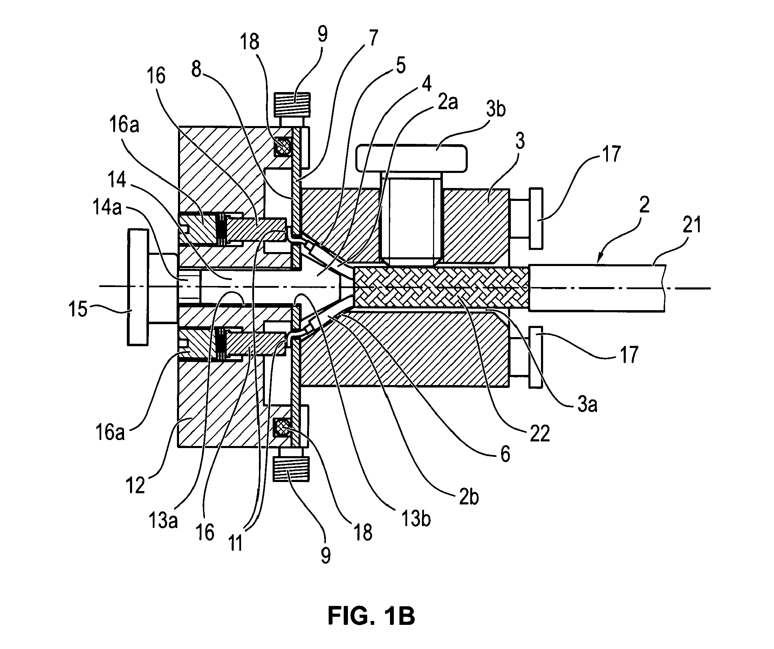

In der Verlängerung des Kabels 2, d.h. in Fig. 1A/1B links von der Halterung 3, ist eine Messadapter-Einheit angeordnet. Die Messadaptereinheit umfasst den Spreizkörper 4 und eine Leiterplatte 7. Der Spreizkörper 4 ist kegelstumpfförmig gebildet und rotationssymmetrisch um die Längsachse 10.

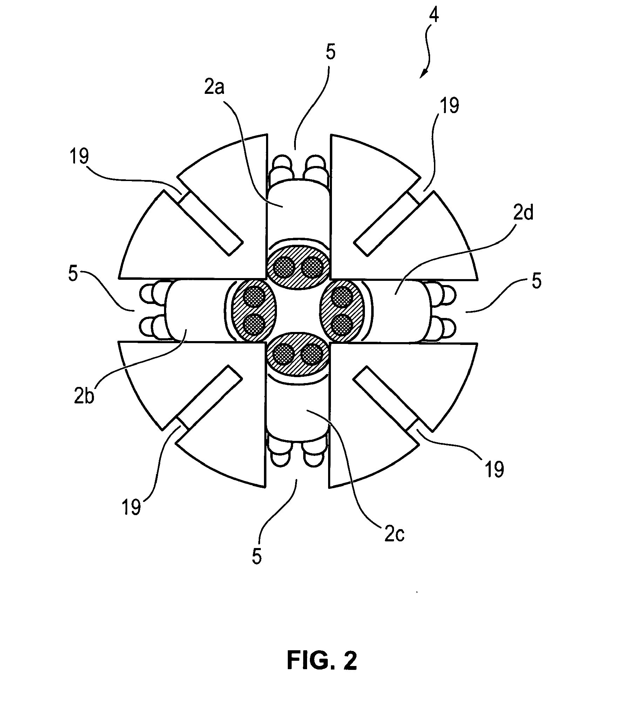

Wie in der Seitenansicht in Fig. 2 gezeigt, sind in der Mantelfläche des Spreizkörpers 4 im Winkelabstand von 90° vier längliche Vertiefungen 5 gebildet, in denen jeweils ein Leiterpaarende 2a-2d angeordnet ist. Die länglichen Vertiefungen 5 sind derart gebildet, dass die Leiterpaarenden 2a-2d entsprechend der Steigung der konusförmigen Mantelfläche des Spreizkörpers 4 nach außen aufgefächert sind (wie in Fig. 1A zu sehen ist). Zwischen jeweils zwei länglichen Vertiefungen 5 sind Nuten 19 gebildet, um Material einzusparen, einen leichteren Aufbau zu erhalten und um die Reibung zwischen der Mantelfläche des Spreizkörpers 4 und der Oberfläche der Aufnahmeausnehmung 6 bei der Drehjustierung zu verringern.

Wieder Bezug nehmend auf die Fig. 1A ist an dem aufgeweiteten Ende des kegelstumpfförmigen Spreizkörpers 4 ein Gewindeschaft 14 mit einem Gewindeabschnitt 14a angeordnet, der sich in den Fig. 1A/1B von dem Spreizkörper 4 aus nach links erstreckt, der - wie nachfolgend genauer beschrieben - zur Fixierung eines Schirmdeckeis 12 benötigt wird. Im Besonderen ist der Schaft 14 mit dem Spreizköper 4 drehfest verbunden.

Auf der der Halterung 3 gegenüberliegenden Seite des Spreizkörpers 4 ist die Leiterplatte 7 senkrecht stehend zur Längsachse 10 an dem kegeistumpfförmigen Spreizkörper 4 angebracht. Die Leiterpaarenden 2a-2d erstrecken sich entlang der länglichen Vertiefungen 5 bis zur Leiterplatte 7 und durch in der Leiterplatte 7 gebildete Leiterdurchführungen zur gegenüberliegenden Leiterplattenseite, auf der Anschlagmittel 11 zum Anschließen der Drähte der Leiterpaarenden 2a-2d angeordnet sind. Die Anschlagmittel 11 sind wiederum mit jeweiligen Leiterbahnen 8 der Leiterplatte 7 verbunden, die sich von den Anschlagmittel 11 radial nach außen zu den Anschlussbuchsen 9, insbesondere Koaxialanschlussbuchsen, erstrecken und mit diesen elektrisch verbunden sind.

Wiederum auf der der Halterung 3 gegenüberliegenden Seite der Leiterplatte 7 ist der Schirmdeckel 14 angeordnet zum Schutz und insbesondere zur Abschirmung der auf der Leiterblatte 7 gebildeten Leiterbahnen 8 und Anschlagmittel 11 der Leiterpaarenden 2a-2d mit den Leiterbahnen 8 sowie der Anschlagmittel 11 der Leiterbahnen 8 mit den Anschlussbuchsen 9. Der Schirmdeckel 12 ist flächenmäßig dergestalt, dass er die gesamte Leiterplattenfläche abdeckt. In dem Schirmdeckel 12 und in der Leiterplatte 7 sind Durchgangsöffnungen 13a, 13b gebildet, durch welche sich der zuvor beschriebene Gewindeschaft 14 erstreckt und mit dem Gewindeabschnitt 14a von der Stirnseite des Schirmdeckeis 12 vorsteht. Eine Deckelverschraubung 15 ist an dem Gewindeabschnitt 14a verschraubbar.

Wie der Fig. 1A weiterhin zu entnehmen ist, sind in dem Schirmdeckel 12 in Richtung der Längsachse 10 verlaufende Durchgangsbohrungen mit darin angeordneten Federstiften 16 gebildet. Die Federstifte 16 sind gegenüber dem Schirmdeckel 12 abgestützt und in Richtung auf die Leiterplatte 7, d.h. in der Figur in Richtung nach rechts, vorgespannt. Auf der der Leiterbahnen 8 zugewandten Seite des Schirmdeckels 12, ist in Umfangsrichtung des Schirmdeckels 12 eine Dichtschnur 18 eingelassen, und zwar derart, dass sie in Richtung auf die Leiterplatte 7 vorsteht. Die Vorspannkraft der Federstifte 16 kann mittels einer Einstellschraube 16a eingestellt werden.

Fig. 1A zeigt in der explodierten Ansicht den modularen Aufbau der Messzange 1. Fig. 1B zeigt den zusammengesetzten Zustand der Messzange 1 mit darin aufgenommem Kabel 2. Um von der in Fig. 1A dargestellten Anordnung zu der in Fig. 1B gezeigte Anordnung zu gelangen, wird zunähst der Schirmdeckei 12 mit Hilfe der Deckelverschraubung 15 an der Leiterplatte 7 fixiert, wobei zusätzlich mittels der Federstifte 16 die Leiterpaarenden 2a-2d an entsprechenden Kontaktstellen der Leitebahnen 8 fixiert werden. Anschließend wird das Kabel 2 zusammen mit der Anordnung aus Schirmdeckel 12, Leiterplatte 7 und Spreizkörper 4 in Richtung nach rechts gezogen, und zwar derart, dass sich der Spreizkörper 4 in Anlage mit der Innenoberfläche der Aufnahmeausnehmung 6 befindet. In diesem Zustand wird das Kabel 2 mit Hilfe der Fixierschraube 3b in der Halterung 3 fixiert.

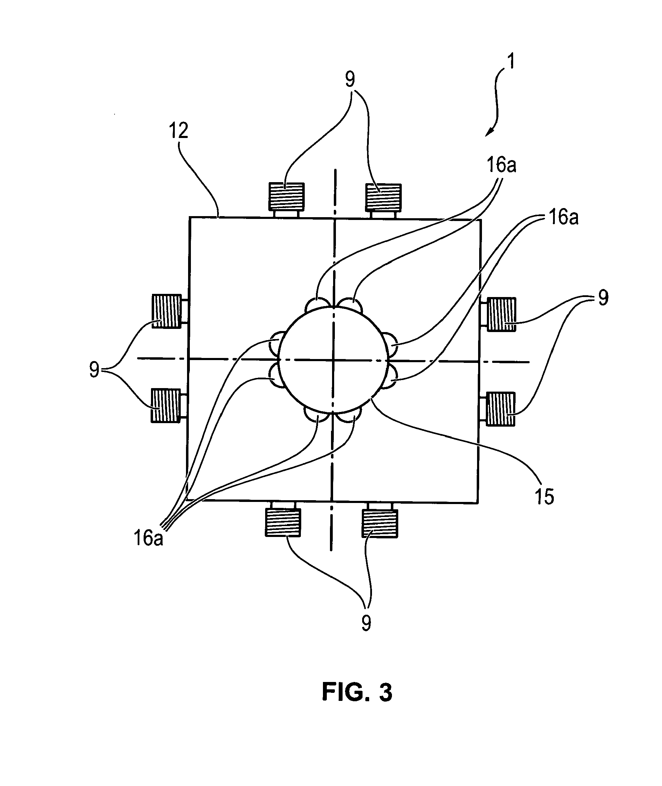

Fig. 3 zeigt die Seitenansicht von links der Messzange 1 in den Fig. 1A/1B. Der Schirmdeckel 12 ist rechteckförmig gebildet. Von den Seiten des Schirmdeckeis 12 stehen die Koaxialanschlussbuchsen 9, nämlich acht an der Zahl, vor. Von der Deckelverschraubung 15 stehen die Einstellschrauben 16a der Federstifte 16, nämlich acht an der Zahl, vor.

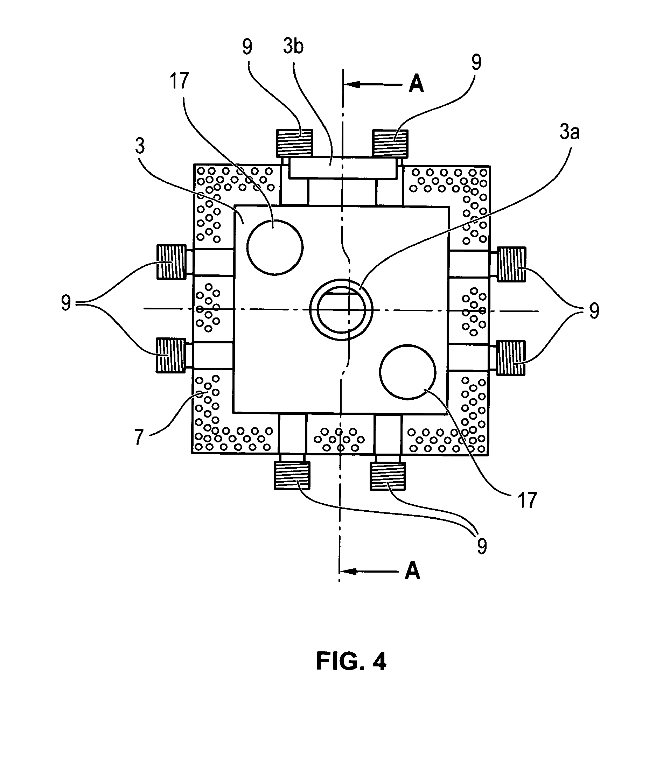

Fig. 4 zeigt die Seitenansicht von rechts der Messzange 1 in den Fig. 1A/1B. Die Halterung 3 ist rechteckförmig gebildet. Von den Seiten der Halterung 3 steht die Leiterplatte 7 vor mit den daran angebrachten Anschlussbuchsen 9. Die Anschlussbuchsen 9 wiederum stehen von der Leiterplatte 7 ab. In der Halterung ist die Längsrille 3a zur Aufnahme des zu messenden Kabels 2 gebildet. Ferner sind zwei Spannschrauben 17 zum gegeneinander Verspannen der beiden Spannbacken der Halterung angedeutet. Die Fixierschraube 3b fixiert das Kabel 2 in der gezeigten Position.
- 1: Messzange
- 2: Kabel
- 2a: Leiterpaar
- 2b: Leiterpaar
- 2c: Leiterpaar
- 2d: Leiterpaar
- 3: Halterung
- 3a: Längsrille
- 3b: Fixierschraube
- 4: Spreizkörper
- 5: Längliche Vertiefung
- 6: Aufnahmeausnehmung
- 7: Leiterplatte
- 8: Leiterbahnen
- 9: Anschlussbuchsen
- 10: Längsachse
- 11: Anschlagmittel
- 12: Schirmdeckel
- 13a: Durchgangsöffnung
- 13b: Durchgangsöffnung
- 14: Gewindeschaft
- 14a: Gewindeabschnitt
- 15: Deckelverschraubung
- 16: Federstift
- 16a: Einstellschraube
- 17: Spannschraube
- 18: Dichtschnur
- 19: Nuten
- 20: Längsachse
- 21: Kabelmantel
- 22: Kabelschirm

## Patentansprüche

1. Messzange (1) zur Adaptierung zwischen einem symmetrischen Datenkabel (2) mit mehreren Leiterpaaren (2a-2d) und den asymmetrischen Messtoren eines Netzwerk-Analysegeräts zur Messung der charakteristischen HF-Eigenschaften des Kabels (2), mit einer Halterung (3) zum Fixieren eines Endes des zu messenden Kabels (2), **gekennzeichnet durch** einen sich in Längsrichtung verjüngenden Spreizkörper (4) mit in der Mantelfläche des Spreizkörpers (4) gebildeten länglichen Vertiefungen (5) zum Einlegen und rotationssymmetrischen Aufspreizen der Leiterpaarenden des Kabels (2).

2. Messzange (1) nach Anspruch 1,
**dadurch gekennzeichnet, dass**
in der Halterung (3) eine Aufnahmeausnehmung (6) gebildet ist, in der der Spreizkörper (4) mit dem verjüngten Ende der Halterung (3) zugewandt zumindest teilweise derart aufnehmbar ist, dass die Längsachse (10) des Spreizkörpers (4) mit der Längsachse (20) des Kabels (2) zusammenfällt.

3. Messzange (1) nach Anspruch 2,
**dadurch gekennzeichnet, dass**
in der Mantelfläche des Spreizkörpers (4) und/oder der Innenoberfläche der Aufnahmeausnehmung (6) die länglichen Vertiefungen (5) gebildet sind, derart, dass im Zusammenwirken von Spreizkörper (4) und Aufnahmeausnehmung (6) je Leiterpaar (2a-2d) ein separater, in Umfangsrichtung geschlossener Schirmkanal gebildet wird.

4. Messzange (1) nach Anspruch 2 oder 3,
**dadurch gekennzeichnet, dass**
die Aufnahmeausnehmung (6) im Wesentlichen mit der Grundform des Spreizkörpers (4) korrespondiert.

5. Messzange (1) nach einem der vorhergehenden Ansprüche,
**dadurch gekennzeichnet, dass**
der Spreizkörper (4) pyramidenförmig mit einem regelmäßigen oder punktsymmetrischen Polygon als Grundfläche, insbesondere pyramidenstumpfförmig und vorzugsweise kegelförmig, insbesondere kegelstumpfförmig gebildet ist.

6. Messzange (1) nach einem der vorhergehenden Ansprüche,
**dadurch gekennzeichnet, dass**
die Vertiefungen (5) im Querschnitt trapezförmig, insbesondere rechteckförmig, dreieckförmig oder halbrundförmig sind.

7. Messzange (1) nach einem der vorhergehenden Ansprüche,
**dadurch gekennzeichnet, dass**
auf dem aufgeweiteten Ende des Spreizkörpers (4) senkrecht zu dessen Längsachse (10) eine Leiterplatte (7) mit, vorzugsweise vergoldeten, radialen Leiterbahnen (8) angeordnet ist, zum Verbinden der Kabelpaarenden (2a-2d) mit jeweiligen Anschlussbuchsen (9), insbesondere Koaxialanschlussbuchsen, die radial weiter außen in gleichem Abstand von der Längsachse (10) liegend in Umfangsrichtung der Leiterplatte (7) angeordnet sind.

8. Messzange (1) nach Anspruch 7,
**dadurch gekennzeichnet, dass**
die Leiterbahnen (8) auf der der Halterung (3) gegenüberliegenden Seite der Leiterplatte (7) angeordnet sind.

9. Messzange (1) nach Anspruch 7 oder 8,
**dadurch gekennzeichnet, dass**
Anschlagmittel (11) zum Verbinden der Leiterpaarenden (2a-2d) mit den Leiterbahnen (8) in gleichen Abständen von der Spreizkörperlängsachse (10) angeordnet sind.

10. Messzange (1) nach einem der Ansprüche 7 bis 9,
**dadurch gekennzeichnet, dass**
ein Schirmdeckel (12) an der der Halterung (3) gegenüberliegenden Seite der Leiterplatte (7) angeordnet ist, zur Abschirmung der Leiterbahnen (8) und der daran angeschlossenen Kabelenden (2a-2d) und Anschlussbuchsen (9).

11. Messzange (1) nach Anspruch 10,
**dadurch gekennzeichnet, dass**
in der Leiterplatte (7) und in dem Schirmdeckel (12) zentrale Durchgangsöffnungen (13a, 13b) mit einem kleineren Durchmesser als das aufgeweitete Ende des Spreizkörpers (4) gebildet sind, und an dem aufgeweiteten Ende des Spreizkörpers (4) ein Schaft (14) mit einem Gewindeabschnitt (14a) angeordnet ist, der sich durch die Durchgangsöffnungen (13a, 13b) erstreckt, zur Verschraubung mit einer Deckelverschraubung (15), um die Leiterplatte (7) gegen den Schirmdeckel (12) zu fixieren.

12. Messzange (1) nach Anspruch 11,
**dadurch gekennzeichnet, dass**
in dem Schirmdeckel (12) in Richtung auf den Spreizkörper (4) vorgespannte Federstifte (16) angeordnet sind, derart, dass bei Verschraubung des Schirmdeckels (12) mittels der Deckelverschraubung (15) die Leiterpaarenden und die Leiterbahnen durch die Federstifte (16) mit einer definierten gleichbleibenden Kraft entsprechend der Vorspannkraft der Federstifte (16) miteinander in Kontakt gedrückt werden.
